# EUROPEAN PATENT SPECIFICATION

(11) **EP 3 748 845 B1**
(45) Date of publication and mention of the grant of the patent: **01.07.2026**
(21) Application number: 19746715.2
(22) Date of filing: 31.01.2019
(51) Int. Cl.: H02H 3/08, H03F 1/52, H03F 3/193, H03F 3/24, G01R 19/165, H10D 89/60

(54) **PROTECTION CIRCUIT AND CIRCUIT PROTECTION METHOD**
SCHUTZSCHALTUNG UND SCHALTUNGSSCHUTZVERFAHREN
CIRCUIT DE PROTECTION ET PROCÉDÉ DE PROTECTION DE CIRCUIT

(30) Priority: 31.01.2018 CN 201810094652
(43) Date of publication of application: 09.12.2020
(73) Proprietor: ZTE Corporation, Shenzhen, Guangdong 518057 (CN)
(72) Inventor: MA, Jun, Shenzhen, Guangdong 518057 (CN); ZHANG, Qi, Shenzhen, Guangdong 518057 (CN); WEI, Dong, Shenzhen, Guangdong 518057 (CN)
(74) Representative: WBH Wachenhausen Patentanwälte PartG mbB
(86) International application number: PCT/CN2019/074063
(87) International publication number: WO 2019/149236

(56) References cited:
- CN-A- 102 055 412
- CN-A- 102 271 425
- CN-A- 106 412 761
- CN-A- 108 574 462
- CN-U- 202 772 843
- CN-U- 204 408 279
- CN-U- 206 272 476
- JP-A- H09 199 950
- US-A- 4 878 034
- US-A- 4 965 692
- US-A1- 2005 174 178
- US-A1- 2007 053 128
- WANG JUN ET AL: "Integrated switch current sensor for shortcircuit protection and current control of 1.7-kV SiC MOSFET modules", 2016 IEEE ENERGY CONVERSION CONGRESS AND EXPOSITION (ECCE), 1 September 2016 (2016-09-01), pages 1 - 7, XP055846016, ISBN: 978-1-5090-0737-0, DOI: 10.1109/ECCE.2016.7855210
- ZHANG XUAN ET AL: "A Gate Drive With Power Over Fiber-Based Isolated Power Supply and Comprehensive Protection Functions for 15-kV SiC MOSFET", IEEE JOURNAL OF EMERGING AND SELECTED TOPICS IN POWER ELECTRONICS, IEEE, PISCATAWAY, NJ, USA, vol. 4, no. 3, 1 September 2016 (2016-09-01), pages 946 - 955, XP011618072, ISSN: 2168-6777, [retrieved on 20160729], DOI: 10.1109/JESTPE.2016.2586107

## Description

### TECHNICAL FIELD

The present application relates to the field of circuit protection, for example, to a protection circuit, a circuit protection method and a computer program.

### BACKGROUND

The 5th-Generation (5G) technology, driven by the mobile internet and the internet of things, has broad application prospects. Multiple Input Multiple Output (MIMO) technology has been widely used in the 4th-Generation (4G) system, and Massive MIMO technology is one of the key technologies in the 5G wireless system. In the face of performance challenges of 5G in terms of transmission rate and system capacity, the further increase in the number of antennas will still be an important direction for MIMO technology to continue to evolve.

For example, the power amplifier in a base station is typically designed as a multi-channel architecture, and the power supply for the power amplifier usually adopts a power sharing scheme. When one channel of the power amplifier has a short-circuited drain, the power from the power supply will be biased, which will affect the normal operation of other channels.

In the related art, the protection circuit generally protects the drain of the power amplifier by blowing a fuse. In this method, it takes a long time for the fuse to be thermally blown, which cannot prevent the power amplifier from burning out in time.

In view of the above problems in the related art, no effective solutions have been found yet.

Document "A Gate Drive With Power Over Fiber-Based Isolated Power Supply and Comprehensive Protection Functions for 15-kV SiC MOSFET" presents a 15kV silicon carbide (SiC) MOSFET gate drive, which features high common-mode (CM) noise immunity, small size, light weight, and robust yet flexible protection functions. To enhance the gate-drive power reliability, a power over fiberbased isolated power supply is designed to replace the traditional design based on isolation transformer. It delivers the gate-drive power by laser light via optical fiber over a long distance (>1 m), so a high isolation voltage (>20 kV) is achieved, and the circuit size and weight are reduced. More importantly, it eliminates the parasitic CM capacitance coupling the power stage and control stage, and thus eradicates the control signal distortion caused by high dv/dt in switching transients of the high-voltage SiC devices.

### SUMMARY

The following is a summary of the subject matter described in detail herein. This summary is not intended to limit the protection scope of the claims.

According to some embodiments of the present application, a protection circuit, a circuit protection method and a computer program are provided. The features of the protection circuit, the circuit protection method and the computer program according to embodiments of the present application are set out in the appended set of claims.

Other aspects will become apparent after reading and understanding the drawings and detailed description.

### BRIEF DESCRIPTION OF DRAWINGS

The drawings are provided for a further understanding of the present application, and constitute a part of the present application. Illustrative embodiments of the present application and descriptions thereof are used to explain the present application and do not constitute an improper limitation of this application, in which:
Fig. 1 is a first structural diagram of a protection circuit according to an embodiment of the present application which is partially covered by the scope of protection of the claims;
Fig. 2 is a second structural diagram of the protection circuit according to an embodiment of the present application which is covered by the scope of protection of the claims;
Fig. 3 is a schematic diagram showing application of a protection circuit for a power amplifier according to implementation one which is covered by the scope of protection of the claims;
Fig. 4 is a response curve of the protection circuit when there is no abnormality protection during initial power-on according to implementation one;
Fig. 5 is a response curve of the protection circuit when the gate voltage is abnormal according to implementation one;
Fig. 6 is a diagram of a normal peak-to-average ratio input signal according to implementation one;
Fig. 7 is a response curve of the protection circuit to an input peak-to-average ratio signal according to implementation one;
Fig. 8 is a graph of an abnormal input signal according to implementation one;
Fig. 9 is a response curve of the protection circuit to an input abnormal signal according to implementation one;
FIG. 10 is a schematic diagram showing an application in which a protection threshold is adjustable by hardware according to implementation two which is covered by the scope of protection of the claims.
FIG. 11 is a schematic diagram showing an application in which a protection threshold is adjustable by software according to implementation two;
FIG. 12 is a first schematic diagram showing an application in which a response time is adjustable by hardware according to implementation three which is covered by the scope of protection of the claims;
FIG. 13 is a second schematic diagram showing an application in which a response time is adjustable by hardware according to implementation three;
FIG. 14 is a third schematic diagram showing an application in which a response time is adjustable by hardware according to implementation three;
FIG. 15 is a forth schematic diagram showing an application in which a response time is adjustable by software according to implementation three;
FIG. 16 is a schematic diagram showing an application in which a delay module is adjustable by hardware according to implementation four which is covered by the scope of protection of the claims;
FIG. 17 is a schematic diagram showing an application in which a delay module is adjustable by software according to implementation four; and
FIG. 18 is schematic diagram showing an application in which a protection circuit for a drain of a power amplifier is dynamically adjustable by software according to implementation five which is covered by the scope of protection of the claims.

Hereinafter, whenever an embodiment/implementation is described, reference is to be made to the above figure list to determine whether the embodiment/implementation is to be read as covered by the scope of protection of the claims or as an embodiment/implementation which is partially covered by the scope of protection of the claims.

### DETAILED DESCRIPTION

The present application will be described in detail with reference to the accompanying drawings and in conjunction with embodiments. It is to be noted that if not in collision, the embodiments and features therein in the present application may be combined with each other.

It is to be noted that terms "first", "second" and the like in the description, the claims and the drawings are used for distinguishing similar objects, but not necessarily used for describing a specific sequence or a precedence order.

### Embodiment one

The application scenarios of a protection circuit according to an embodiment of the application include: a protection circuit for a power supply of a power amplifier in a power sharing base station, a circuit system using a field effect transistor, etc.

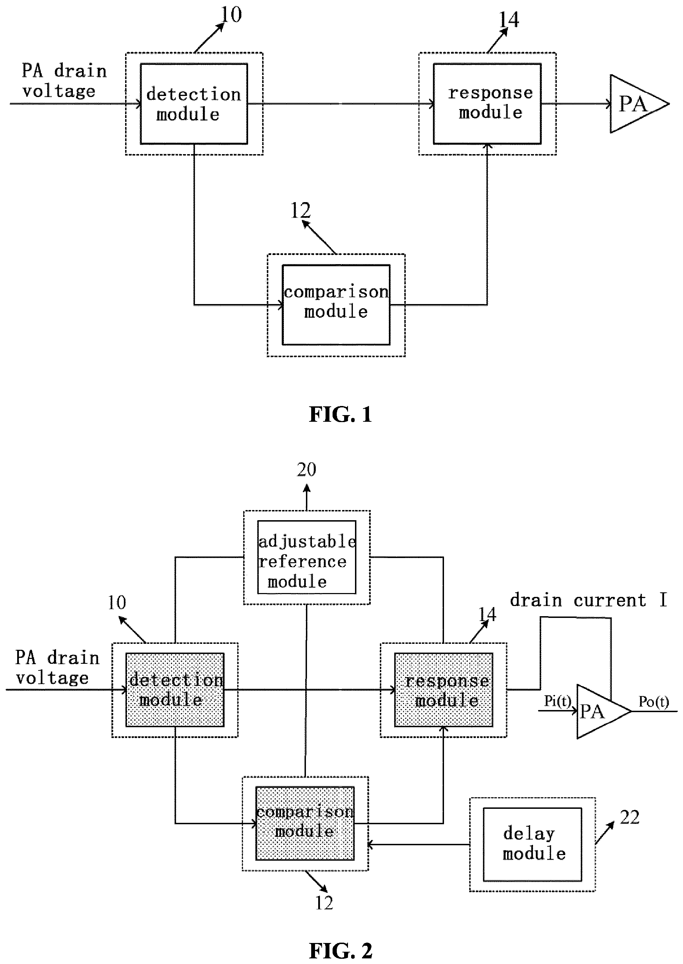

In this embodiment, a protection circuit is provided. Fig. 1 is a first structural diagram of the protection circuit according to the embodiment of the present application. As shown in Fig. 1, the protection circuit includes a detection module 10, a comparison module 12 and a response module 14.

The detection module 10 is connected with a drain of a Power Amplifier (PA), and configured to detect a dynamic current in the drain of the PA and output the dynamic current to the comparison module.

The comparison module 12 is connected with the detection module, and configured to output a control signal to the response module after a first response time in response to determining that the dynamic current is greater than a sampling threshold.

The response module 14 is connected with the comparison module, and configured to control the switch-off and switch-on of a drain voltage of the PA based on the control signal after a second response time.

Through the above steps, by limiting the drain current of the PA, when there is an abnormality in a certain channel of the PA, the abnormal channel can be quickly switched off without affecting the normal operation of other channels. Moreover, due to its fast response speed, the power amplifier can be effectively prevented from being burned out due to large gate voltage, short circuit, abnormal large signal, etc., and the situation of power supply bias caused by PA burnout due to long response time of the protection circuit in the related art is avoided. By setting a sampling threshold and a response time of the circuit, the burnout of the PA under extreme conditions is avoided, thereby increasing the reliability and stability of the system.

In an embodiment, the circuit further includes an adjustable reference module which is connected with the detection module and configured to adjust the sampling threshold for the dynamic current. By adding the adjustable reference module to adjust the sampling threshold, a protection threshold of the protection circuit can be adjusted.

In an embodiment, the adjustable reference module is connected with the comparison module and configured to adjust the first response time. In an embodiment, the adjustable reference module is connected with the response module and configured to adjust the second response time. By adding the adjustable reference module, the response time of the protection circuit can be adjusted.

In an embodiment, the circuit further includes a delay module which is connected with the comparison module and configured to control a state of an enabled terminal of the comparison module. By adding the delay module to control the power-on time of a signal at the enabled terminal of the comparison module, the system can be prevented from false protection during power-on. The protection circuit has an enabling function. By adding the enabling function, the comparison module is also enabled to control whether the protection is effective or not.

In an embodiment, corresponding functions of the adjustable reference module may be implemented by software or hardware.

When adjusting the sampling threshold and the state of the enabled terminal, the adjustable reference module, when implemented by hardware, includes an adjustable resistor connected between a ground terminal and the comparison module and configured to adjust a reference voltage of the comparison module, the reference voltage corresponds to the sampling threshold. According to Ohm's law, the current is proportional to the voltage under the condition of constant resistance, so the sampling threshold can be adjusted by adjusting the reference voltage. The adjustable reference module, when implemented by software includes: a central processing unit/processor (CPU), a Field-Programmable Gate Array (FPGA) and a Digital to Analog converter (DAC). An input terminal of the CPU is configured to receive control instructions, and an output terminal of the CPU is connected with the FPGA and configured to control the FPGA based on the control instructions. An input terminal of the FPGA is connected with the CPU, and an output terminal of the FPGA is connected with the DAC and the comparison module and configured to control the state of the enabled terminal by adjusting an output level and set the reference voltage, where the reference voltage corresponds to the sampling threshold. An input terminal of the DAC is connected with the FPGA, and an output terminal of the DAC is connected with comparison module and configured to output the reference voltage.

When adjusting the response time (including the first response time and the second response time), the adjustable reference module, when implemented by hardware, includes at least one of:
a first capacitor, which is connected between the detection module and the comparison module, and configured to adjust a value of time for the output of the dynamic current to the comparison module;
an adjusting unit, which includes a first resistor and a second capacitor, and configured to adjust a value of time for the output of the dynamic current to the comparison module, the first resistor being connected between the ground terminal and the comparison module, the second capacitor being connected in parallel with the first resistor, and the second capacitor being connected between the ground terminal and the comparison module;
a Resistance-Capacitance (RC) phase-shifting circuit, which is connected in parallel with the a gate input terminal of the PA, includes a second resistor and a third capacitor, and is configured to adjust the second response time, the second resistor being connected between the gate input terminal and the ground terminal, and the third capacitor being connected between the gate input terminal and the ground terminal.

The adjustable reference module, when implemented by hardware, includes: a CPU, a FPGA, and a first counter circuit. An input terminal of the CPU is configured to receive control instructions, and an output terminal of the CPU is connected with the FPGA and configured to control the FPGA based on the control instructions. An input terminal of the FPGA is connected with the CPU, and an output terminal of the FPGA is connected with the first counter circuit and configured to control the first counter circuit. An input terminal of the first counter circuit is connected with the FPGA, and an output terminal of the first counter circuit is connected with the comparison module and configured to control the first response time.

In an embodiment, corresponding functions of the delay module may be implemented by software or hardware. Specifically, when implemented by hardware, the delay module includes a RC phase-shifting circuit including a fourth capacitor and a third resistor. The power-on sequence of the enabled terminal is adjusted by adjusting the resistance value of the resistor and the capacitance value of the capacitor. The fourth capacitor and the third resistor are connected in parallel, with one end of the fourth capacitor and one end of the third resistor grounded together, and the other end of the fourth capacitor and the other end of the third resistor connected to the enabled terminal together. The resistance value of the third resistor and the capacitance value of the fourth capacitor are adjusted so that the enabled terminal is disabled when the power supply overshoots, and the protection circuit does not have a protection function, thus avoiding false system protection.

When implemented by software, the delay module includes a second counter circuit configured to adjust a power-on level of the enabled terminal to control the enabling state of the enabled terminal.

Fig. 2 is a second structural diagram of the protection circuit according to an embodiment of the present application. As shown in Fig. 2, on the basis of Fig. 1, the protection circuit further includes an adjustable reference module 20 and a delay module 22.

In an embodiment, the adjustable reference module adjusts the sampling threshold based on at least one of a maximum withstand power of the PA, a wideband signal capability of the PA, requirements of the system to which the PA belongs, and the peak-to-average ratio of the dynamic current.

In an embodiment, the delay module controls the enabled terminal of the comparison module to be in a disabled state for a predetermined time after the drain voltage of the PA is switched on. Specifically, the delay module detects the switch-on time of the drain voltage, and waits for a predetermined time after detecting that the voltage is switched on, thereby avoiding false protection. Since the drain will have an overshoot current when the drain voltage of the PA is switched on, by adjusting the delay module to control the response module, the system can be prevented from false protection upon powering on, thereby increasing the stability of the system.

In this embodiment, the PA includes one of Gallium Nitride (GaN) PA and laterally diffused metal oxide semiconductor (LDMOS) PA. Of course, other application scenarios are also possible.

It should be noted that the above modules may be implemented by software or hardware, and when implemented by the hardware, the modules may be implemented in the following manners including, but not limited to: all the above modules are located in the same processor; or, the above modules are located in different processors in any combination.

### Embodiment two

In this embodiment, a circuit protection method is provided for realizing the above embodiments and exemplary implementations, and what has been described will not be repeated herein again.

In this embodiment, a circuit protection method is provided for protecting the PA by using the protection circuit in Embodiment one. The protection circuit includes: a detection module, a comparison module, and a response module. The detection module is connected with a drain of the PA, and configured to detect a dynamic current in the drain of the PA and output the dynamic current to the comparison module. The comparison module is connected with the detection module and configured to output a control signal after a first response time in response to determining that the dynamic current is greater than a sampling threshold. The response module is connected with the comparison module and configured to control the switch-off and switch-on of a drain voltage of the PA based on the control signal after a second response time.

In this embodiment, a circuit protection method is further provided, which corresponds to the implementation principle of the protection circuit. The circuit protection method includes: detecting a dynamic current in a drain of a PA; outputting a control signal after a first response time in response to determining that the dynamic current is greater than a sampling threshold; and controlling the switch-off or switch-on of a drain voltage of the PA based on the control signal after a second response time.

In an embodiment, before detecting the dynamic current in the drain of the PA, the method further includes adjusting at least one control parameter selected from a group consisting of the sampling threshold, the first response time, and the second response time.

In an embodiment, before outputting the control signal, the method further includes adjusting an enabled state of an output terminal, and the output terminal is configured to output the control signal.

In an embodiment, the adjusting an enabled state of an output terminal includes adjusting an output level of FPGA. A high level and a low level correspond to different states of the output terminal, such as an enabled state and a disabled state, respectively.

In an embodiment, the adjusting at least one control parameter includes setting a reference voltage which corresponds to the sampling threshold; and adjusting a value of time for the output of the dynamic current, i.e., a time from when the dynamic current is detected to when the dynamic current is output to the comparison module, which compares whether the dynamic current is greater than the sampling threshold.

In an embodiment, the adjusting an enabled state of an output terminal includes controlling the enabled state to be a disabled state for a predetermined time after the drain voltage of the PA is switched on.

This protection circuit may also be an optional implementation in Embodiment one and what has been described will not be repeated again.

Through the above description of the foregoing embodiments, those skilled in the art can clearly understand that the above method embodiments can be implemented by means of software plus a necessary general hardware platform; they certainly can also be implemented by means of hardware. Based on this understanding, the essential part of the technical solution according to the present disclosure or the part that contributes to the prior art can be embodied in the form of a software product that can be stored in a storage medium, such as ROM/RAM, a magnetic disk, an optical disc, which includes instructions to cause a terminal device (e.g., a mobile phone, a computer, a server, or a network device, etc.) to perform the methods described in the various embodiments of the present disclosure.

### Embodiment three

In this embodiment, a design scheme related to a power supply protection circuit for a drain of a power amplifier is provided. Under abnormal conditions, such as welding failure of a PA, large gate voltage, large RF signal input, wide spectrum, etc., short circuit of the drain of the PA or burnout of the PA may be caused, leading to bias of the overall power supply, which in turn causes abnormal operation of all transmission channels.

In this embodiment, a method is provided. According to the method, by limiting the drain current of the power amplifier, when there is an abnormality in a certain channel of the power amplifier, the abnormal channel can be quickly switched off without affecting the normal operation of other channels. Moreover, due to its fast response speed, the power amplifier can be effectively prevented from being burned out due to large gate voltage, short circuit, abnormal large signal, etc.

According to the present application, burnout of the PA and bias of the overall power supply caused by the burnout of the PA can be prevented. As shown in Fig. 2, a protection circuit for a drain of a power amplifier (PA) described in the present application includes a detection module 10, a response module 14, a comparison module 12, an adjustable reference module 20 and a delay module 22.

The detection module 10 is configured to detect a real-time dynamic current in the drain of the PA, which may be implemented by using a detection resistor. An input of the detection module 10 is a drain voltage of the PA, and a sampling current is obtained through the detection resistor and is then input to the comparison module 14 through a differential resistor. In addition, the drain voltage of the PA is input into the response module 14 to supply power to the drain of a PA.

The response module 14 is configured to control the switch-off and switch-on of the drain voltage of the PA, which can be implemented by a photoelectric coupler and a positive channel metal oxide semiconductor (PMOS) transistor.

The sampling current from the detection module 10 is input into the comparison module 12, and the comparison module 12 controls the response module 14. When the comparison module 12 outputs a high level, the photoelectric coupler is switched on, and the PMOS transistor is switched off which in turn switches off the drain voltage of the PA. The adjustable reference module 20 controls the response time of the response module 14 to make the response time adjustable.

The adjustable reference module 20 is configured to set a protection current threshold for the PA and a response time of the protection circuit. For different systems, the rated power and system response time are different, and the protection current threshold and the protection response time can be adjusted by adjusting the adjustable reference module 20.

The adjustable reference module 20 controls the detection module 10, and the response module 14 can adjust the response time of the protection circuit. The adjustable reference module 20 controls the comparison module 10 to make the protection threshold and response time adjustable.

The drain current sampled by the detection module 10 passes through the operational amplifier D1 to output a voltage U1, which is compared with a reference voltage U2 in the operational amplifier D2 to output a high or a low level, so as to control the response module, and the response module 14 controls the switch-off of the drain voltage of PA. The adjustable reference module 20 controls the comparison module 12 to adjust the threshold of the protection circuit and the response time of the protection circuit.

The delay module 22 controls the power-on time of a signal at the enabled terminal of the comparison module 12, so as to avoid false protection by the protection circuit when the PA is powered on. In addition, the delay module 22 adjusts the comparison module 12 to control whether the protection circuit is in an enabled state.

The modules in this embodiment may be implemented by hardware, software or a combination thereof, and may be circuits in various forms, which will be described in detail by specific implementations below.

### Implementation one

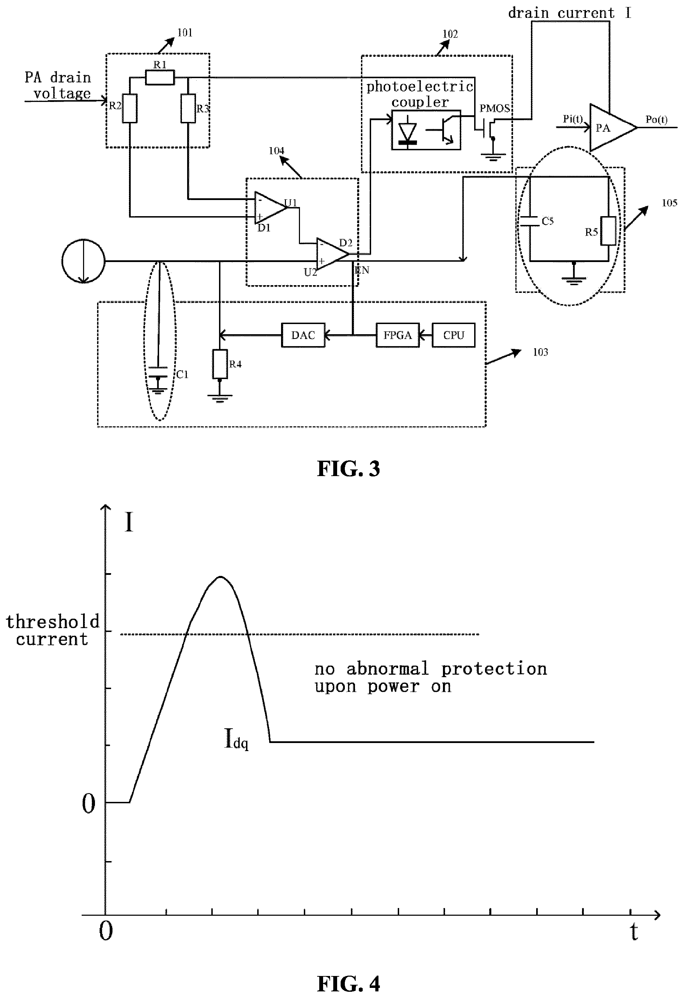

The protection circuit in this implementation has the characteristics of adjustable protection threshold and adjustable response time. The specific application flow chart is shown in Fig. 3, which is a schematic diagram showing application of a protection circuit for a drain of a PA according to implementation one.

Referring to Fig. 3, a current detection module 101, a response module 102, an adjustable reference module 103, a comparison module 104, and a delay module 105 are shown.

After passing through the module 101, the PA drain voltage passes through a sampling resistor, and a sampled drain current passes through a differential resistor and is input to the module 104. The module 104 outputs a high or a low level through the operational amplifiers D1 and D2 to control the module 102, so as to switch off the PA drain voltage. In addition, modules 101, 102 and 104 are controlled by the module 103 to realize the adjustable protection threshold and adjustable response time. By adjusting the module 104 by the module 105, the power-on time of a signal at the enabled terminal 104 and whether the protection circuit is effective or not can be controlled. After the drain voltage of the PA passes through R1 which is the sampling resistor, the sampled current passes through differential resistors R2 and R3 and is input to the operational amplifier D1 to output the voltage U1. The CPU controls the FPGA. On one hand, the FPGA outputs a high or a low level to control the enabled terminal of operational amplifier D2. When the enabled terminal signal is at a high level, D2 works normally, and when the enabled terminal signal is at a low level, D2 is switched off. On the other hand, the FPGA sets the threshold voltage U2 by controlling an output voltage value of the DAC module. The operational amplifier D2 outputs a high or a low level based on a comparison between the voltages U1 and U2. When U1 is greater than U2, D2 outputs a high level, the photoelectric coupler is switched on, and the PMOS transistor is switched off, so that the drain voltage of PA is switched off. When U1 is less than U2, D2 outputs a low level, the photoelectric coupler is switched off, the PMOS transistor remains switched-on, and the circuit works normally.

Since the response times required by different systems are different, the switch-off time of the protection circuit can be changed by adjusting the value of capacitor C1. In addition, when the drain voltage of the PA is switched on, the drain current will overshoot. In order to prevent false protection by the protection circuit, the high-level power-on time of the enabled terminal can be changed by adjusting the capacitance value of a capacitor C5 and the resistance value of a resistor R5 to avoid false protection of the system.

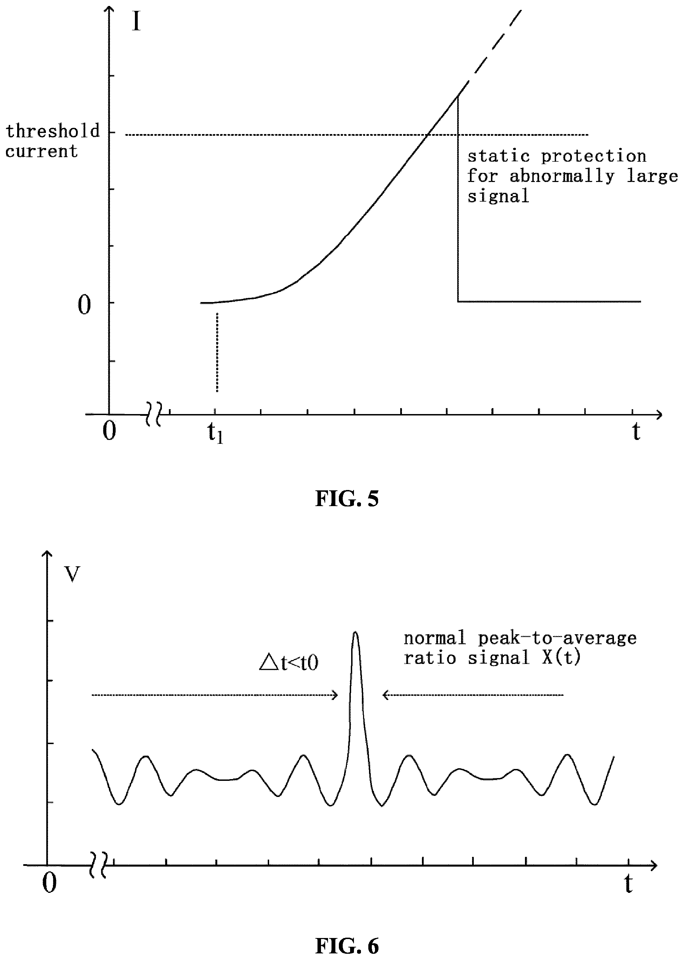

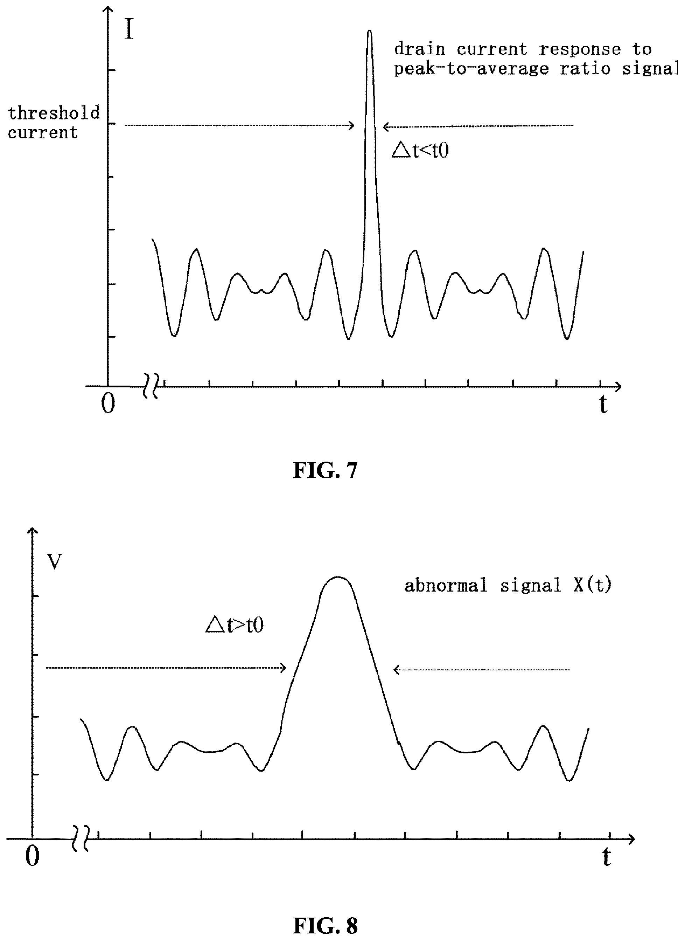

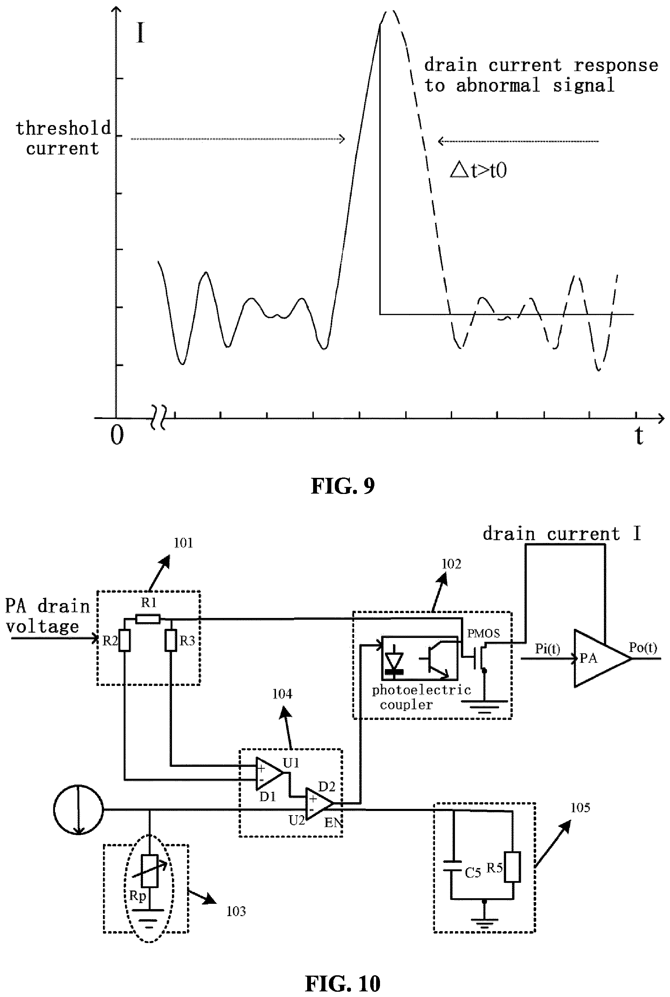

The switch-off response time of the protection circuit is set to be *t*₀ in microsecond (*µs*).
1) When the drain voltage of the PA is switched on, the drain will have an overshoot current. At this time, the response curve of the protection circuit is shown in Fig. 4, which is a response curve of the protection circuit when there is no abnormal protection during the initial power-on according to implementation one. By adjusting the delay module, the drain current of PA is normal and no false protection is caused.
2) When the gate voltage of the PA is abnormal, a large current will occur, and the response curve of the protection circuit is shown in Fig. 5, which is a response curve of the protection circuit when the gate voltage is abnormal according to implementation one. At this time, the protection circuit takes effect, and the drain voltage of PA is switched off to protect the PA.
3) When a peak-to-average ratio signal appears, the duration of the peak-to-average ratio signal is ∇*t* which is less than *t*₀, as shown in Fig. 6, which is a diagram of a normal peak-to-average ratio input signal according to implementation one. The response curve of the protection circuit is shown in Fig. 7, which is a response curve of the protection circuit to the input peak-to-average ratio signal according to implementation one. Comparing Figs. 6 and 7, it can be seen that when the peak-to-average ratio signal appears, and when the duration of the peak-to-average ratio signal is shorter than the switch-off response time of the protection circuit, the drain current of PA is normal, and no false protection is caused.
4) When an abnormal signal occurs, as shown in Fig. 8, which is a graph of the abnormal input signal according to implementation one. The response curve of the protection circuit is shown in Fig. 9, which is a response curve of the protection circuit to the input abnormal signal according to implementation one. Comparing Figs. 8 and 9, it can be seen that when the abnormal signal has an amplitude larger than the protection current threshold and the duration of the abnormal signal is longer than the response time of the protection circuit, the protection circuit takes effect and switches off the drain voltage of PA.

### Implementation two

The protection circuit of this implementation has the characteristic of adjustable threshold, and the protection threshold of PA drain current varies among different systems and different application scenarios.

The threshold current of the protection circuit should be set comprehensively based on the maximum withstand power and wideband signal capability of the PA and the system requirements. If the protection threshold is set too low, the channels of the PA are easily switched off by mistake, and if the threshold is set too high, burnout of the PA is easily caused.

The protection threshold may be adjusted by the hardware circuit. The specific application flow chart is shown in Fig. 10, which is a schematic diagram showing an application in which a protection threshold is adjustable by hardware according to implementation two. The predetermined protection threshold is changed by adjusting a resistance value of a resistor Rp in a voltage dividing circuit.

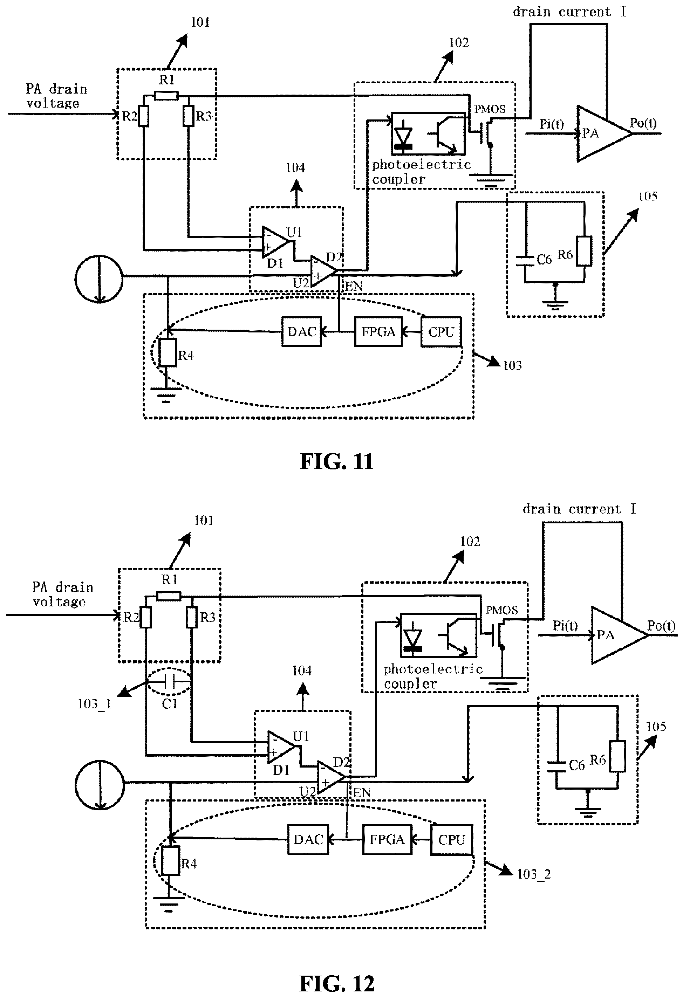

The protection threshold may also be adjusted by software. The specific application flow chart is shown in Fig. 11, which is a schematic diagram showing an application in which a protection threshold is adjustable by software according to implementation two. The CPU controls the FPGA. On one hand, FPGA outputs a high or a low level to control the enabled terminal of the operational amplifier D2. If the enabled terminal signal is at a high level, D2 works normally; and if the enabled terminal signal is at a low level, D2 is switched off. On the other hand, the FPGA sets the threshold voltage U2 by controlling an output voltage value of the DAC module.

The specific application flow charts in this implementation all concern realizable PA drain protection circuit systems.

### Implementation three

The protection circuit of this implementation has the characteristic of adjustable time. Based on different peak-to-average ratio signals, the time required by the system is different, so the characteristic of adjustable time is very important. Time adjustment can be realized by hardware circuit and software module as follows.

The specific application flow chart of a first example of the hardware circuit is shown in Fig. 12. Fig. 12 is a first schematic diagram showing an application in which a response time is adjustable by hardware according to implementation three. The time when the detection current reaches the input terminal of the operational amplifier is adjusted by adjusting the capacitance value of capacitor C1 connected in parallel with detection resistor R1, so as to change the response time of the protection circuit system.

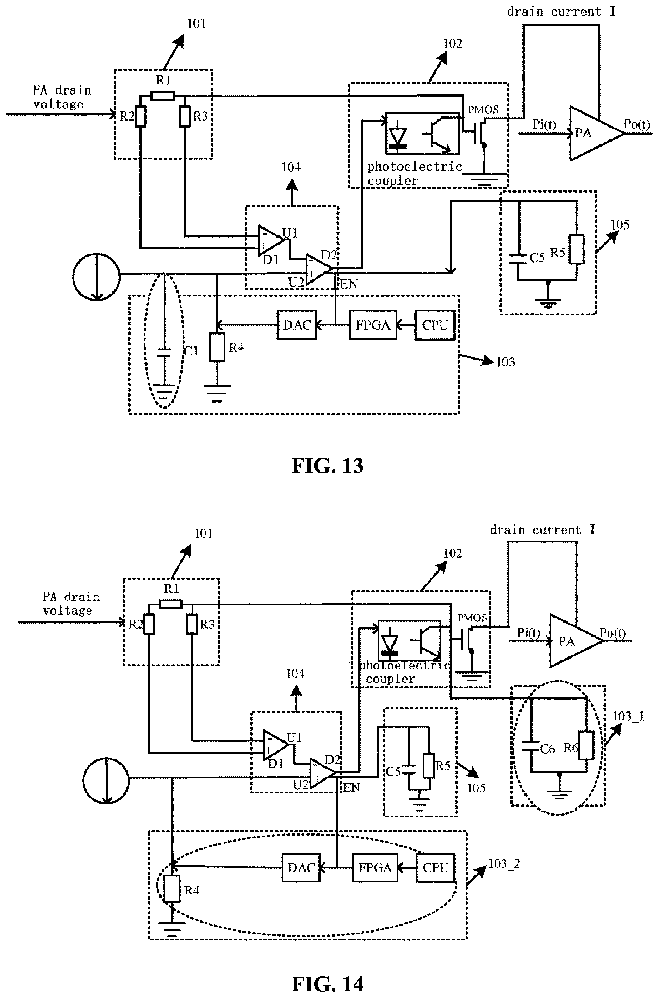

The specific application flow chart of a second example of the hardware circuit is shown in Fig. 13. Fig. 13 is a second schematic diagram showing an application in which a response time is adjustable by hardware according to implementation three. The time when the detection current reaches the input terminal of the operational amplifier is adjusted by adjusting the capacitance value of capacitor C1 connected in parallel with a voltage dividing resistor R4, so as to change the response time of protection circuit system.

The specific application flow chart of a third example of the hardware circuit is shown in Fig. 14. Fig. 14 is a third schematic diagram showing an application in which a response time is adjustable by hardware according to implementation three. The RC phase-shifting circuit is connected in parallel at a gate input terminal of the PMOS transistor, and the resistance value of a resistor R6 and the capacitance value of a capacitor C6 are adjusted to change the response time of the protection circuit system.

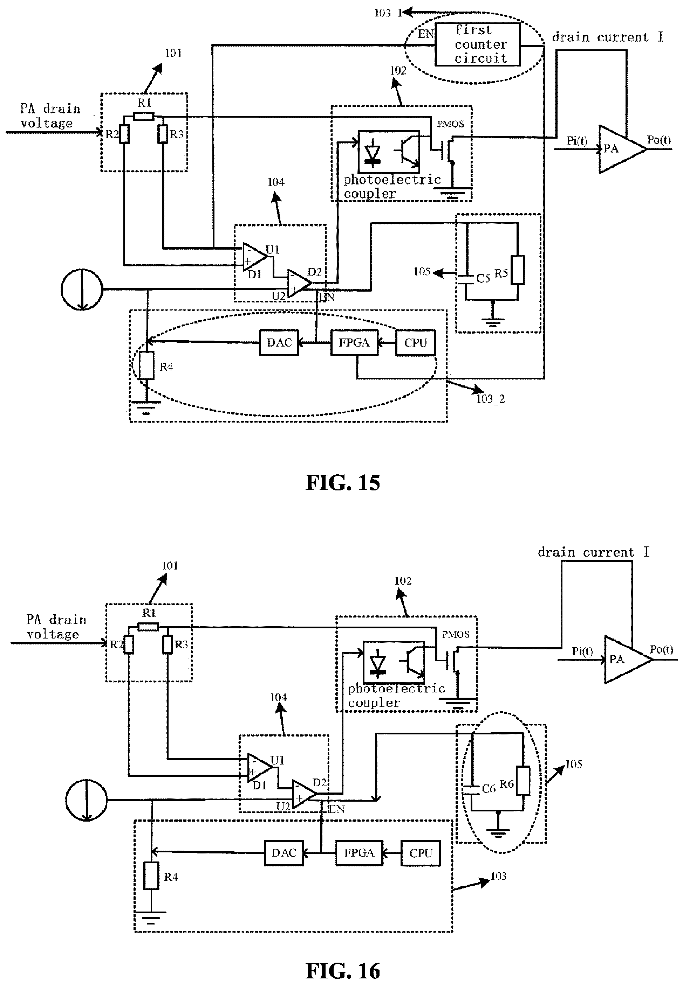

The specific application flow chart realized by software module is shown in Fig. 15. Fig. 15 is a fourth schematic diagram showing an application in which a response time is adjustable by software according to implementation three. A counter circuit is added between the first-stage operational amplifier D1 and the FPGA, and the response time is controlled by the first counter circuit to realize software adjustable response time.

The specific application flow charts in this implementation all concern realizable PA drain protection circuit systems.

### Implementation four

In this implementation, by controlling an enabling module, false protection can be avoided. Since the drain will have an overshoot current when the drain voltage of the PA is switched on, by adjusting the delay module to control the enabling module, the system can be prevented from false protection upon power on, thereby increasing the stability of the system.

A specific flow chart of a process performed by the delay module implemented by hardware is shown in Fig. 16. Fig. 16 is a schematic diagram showing an application in which a delay module is adjustable by hardware according to implementation four. The power-on sequence of the enabled terminal is adjusted through RC network, and the resistance value of the resistor R6 and the capacitance value of the capacitor C6 are adjusted to cause the enabled terminal to be in a disabled state when the power supply overshoots, so that the protection circuit has no protection function, thus avoiding false system protection.

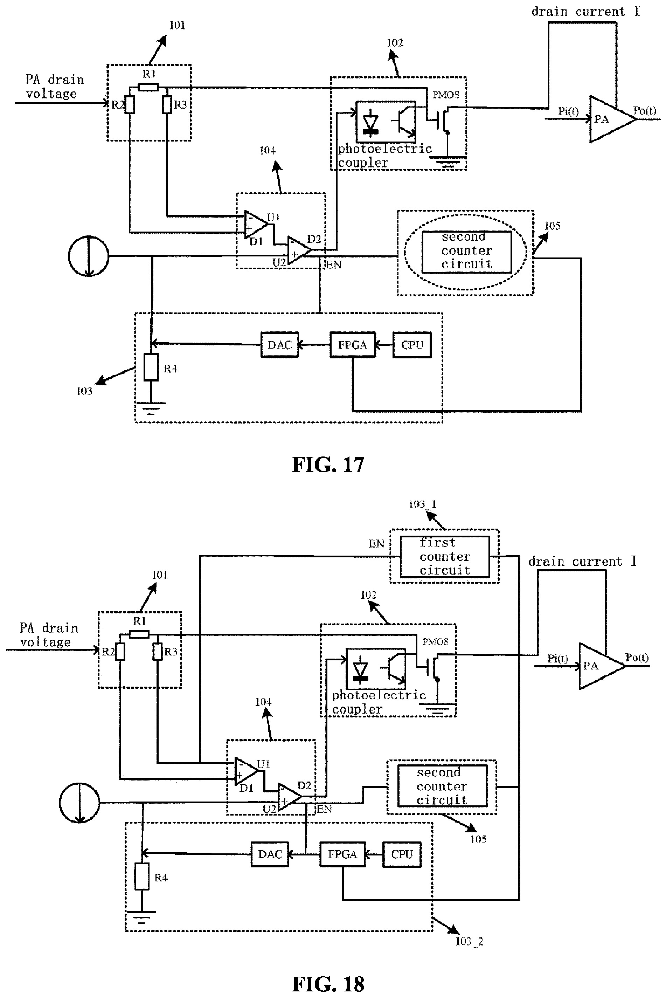

A flow chart of a process performed by the delay module implemented by software is shown in Fig. 17. Fig. 17 is a schematic diagram showing an application in which a delay module is adjustable by software according to implementation four. The FPGA adjusts the power-on level of the enabled terminal of the operational amplifier D2 through the second counter circuit to cause the enabled terminal to be in a disabled state when the power supply overshoots, so that the protection circuit has no protection function, thus avoiding false system protection.

The specific application flow charts in this implementation all concern realizable PA drain protection circuit systems.

### Implementation five

Combined with the implementation two, implementation three and implementation four, an application in which a protection circuit for a drain of a power amplifier is dynamically adjustable by software is shown in Fig. 18. Fig. 18 is a schematic diagram showing an application in which a protection circuit for a drain of a power amplifier is dynamically adjustable by software according to implementation five. Module 103_1 (first counter circuit) adjusts the response time of the protection circuit, and module 103_2 adjusts the protection threshold of the protection circuit. Module 105 (second counter circuit) adjusts the power-on time of the enabled terminal to prevent the protection circuit from false protection when the drain of the power amplifier is switched on, thus realizing the dynamic adjustment by software.

To sum up, the drain protection circuit system is a new type of protection circuit, which can not only protect the large gate voltage, but also effectively block the abnormally large signal output by the system and greatly reduce the burnout probability of the PA. Even if a certain channel of the PA is abnormal, the drain can be effectively disconnected, so that the overall power supply is not affected, and other channels can work normally. For a multi-channel system, this is of vital importance. By shielding abnormal channels and reducing the rank of baseband, the main service will not be affected, thereby improving the overall utilization rate.

Compared with the conventional protection circuit architecture, the protection threshold and the response time of the protection circuit in this embodiment are adjustable by adding the adjustable reference module. By adding the delay module to control the power-on time of the enabled terminal of the comparison module, the system can be prevented from false protection during power-on. The protection circuit has an enabling function. By adding the enabling function, the comparison module is also enabled to control whether the protection is effective or not.

In this embodiment, the protection time is adjustable, so that false protection of peak-to-average ratio signals can be prevented. When large RF signals and wide spectrum signals appear, the response time of the response circuit is controlled to avoid burnout of the PA and increase system reliability. In this embodiment, by controlling the enabling module, false protection can be avoided. Since the drain will have an overshoot current when the drain voltage of the PA is switched on, by adjusting the delay module to control the response module, the system can be prevented from false protection upon power on, thereby increasing the stability of the system. In this embodiment, the response time of the protection circuit system is short, which can be controlled at the microsecond (*µs*) level. In this embodiment, by controlling the switch-off of the drain voltage of PA, it can be avoided that the overall power supply is biased when a certain channel of the PA is burned out. In this embodiment, the protection threshold and response time can be adjusted simply by adding two modules, and the cost is low. This embodiment has a wide range of application scenarios, and the protection method of switching off the PA drain can be applied to both GaN power amplifiers and LDMOS power amplifiers.

### Embodiment four

In an embodiment of the present application, a computer program is further provided comprising instruction to cause the circuit according to claim 1 to execute the method according to claim 8.

## Claims

1. A protection circuit, comprising a detection module (10), a comparison module (12) and a response module (14), wherein the detection module (10) is connected with a drain of a power amplifier, PA, and is configured to detect a dynamic current in the drain of the PA and output the dynamic current to the comparison module (12);
the comparison module (12) is connected with the detection module (10) and configured to, in response to determining that the dynamic current is greater than a sampling threshold, output a control signal to the response module (14) after a first response time started from determining that the dynamic current is greater than the sampling threshold; and
the response module (14) is connected with the comparison module (12) and configured to control switch-off or switch-on of a drain voltage of the PA based on the control signal after a second response time started from receiving the output control signal;
wherein the circuit further comprises an adjustable reference module (20), which is connected with: the detection module (10) to adjust the sampling threshold for the dynamic current; the comparison module (12) to adjust the first response time; and the response module (14) to adjust the second response time.

2. The circuit according to claim 1, further comprising:
a delay module, which is connected with the comparison module and configured to control a state of an enabled terminal of the comparison module.

3. The circuit according to claim 2, wherein the adjustable reference module comprises:
an adjustable resistor, which is connected between a ground terminal and the comparison module and is configured to adjust a reference voltage of the comparison module, wherein the reference voltage corresponds to the sampling threshold.

4. The circuit according to claim 2, wherein the adjustable reference module comprises a central processing unit, CPU, a field programmable gate array, FPGA and a digital-to-analog converter, DAC, wherein,
an input terminal of the CPU is configured to receive a control instruction, and an output terminal of the CPU is connected with the FPGA and configured to control the FPGA based on the control instruction;
an input terminal of the FPGA is connected with the CPU, and an output terminal of the FPGA is connected with the DAC and the comparison module and configured to control the state of the enabled terminal by adjusting an output level and set a reference voltage, wherein the reference voltage corresponds to the sampling threshold;
an input terminal of the DAC is connected with the FPGA, and an output terminal of the DAC is connected with the comparison module and configured to output the reference voltage.

5. The circuit according to claim 2, wherein the adjustable reference module comprises at least one of:
a first capacitor, which is connected between the detection module and the comparison module and configured to adjust a value of time for the output of the dynamic current to the comparison module;
an adjusting unit, which comprises a first resistor and a second capacitor and is configured to adjust a value of time for the output of the dynamic current to the comparison module, wherein the first resistor is connected between the ground terminal and the comparison module, and the second capacitor is connected in parallel with the first resistor between the ground terminal and the comparison module; and
a Resistance-Capacitance, RC, phase-shifting circuit connected in parallel with a gate input terminal of the PA, wherein the RC phase-shifting circuit comprises a second resistor and a third capacitor and is configured to adjust a second response time, wherein the second resistor is connected between the gate input terminal and the ground terminal, and the third capacitor is connected between the gate input terminal and the ground terminal.

6. The circuit according to claim 2, wherein the adjustable reference module comprises a CPU, an FPGA and a first counter circuit, wherein,
an input terminal of the CPU is configured to receive a control instruction, and an output terminal of the CPU is connected with the FPGA and configured to control the FPGA based on the control instruction;
an input terminal of the FPGA is connected with the CPU, and an output terminal of the FPGA is connected with the first counter circuit and configured to control the first counter circuit;
an input terminal of the first counter circuit is connected with the FPGA, and an output terminal of the first counter circuit is connected with the comparison module and configured to control the first response time.

7. The circuit according to claim 2, wherein the delay module comprises at least one of:
a RC phase-shifting circuit, which comprises a fourth capacitor and a third resistor, and power-on sequence of the enabled terminal is adjusted by adjusting a resistance value of the third resistor and a capacitance value of the fourth capacitor; and
a second counter circuit, which is configured to adjust a power-on level of the enabled terminal to control a state of the enabled terminal.

8. A circuit protection method, comprising:
adjusting a sampling threshold for a dynamic current with an adjustable reference module (20) connected with a detection module (10);
adjusting a first response time with the adjustable reference module (20) connected with a comparison module (12);
adjusting a second response time with the adjustable reference module (20) connected with a response module (14);
detecting a dynamic current in a drain of a power amplifier, PA, with the detection module (20) connected to the drain of the PA;
outputting the dynamic current to the comparison module (12) with the detection module (20);
outputting a control signal to the response module (14) after the first response time in response to determining that the dynamic current is greater than the sampling threshold with the comparison module (12) connected with the detection module (10);
and
controlling switch-off or switch-on of a drain voltage of the PA based on the control signal after the second response time started from receiving the output control signal with the response module (14) connected with the comparison module (12).

9. The method according to claim 8, before outputting a control signal, the method further comprises:
adjusting an enabled state of an output terminal, wherein the output terminal is configured to output the control signal.

10. The method according to claim 9, wherein the adjusting an enabled state of an output terminal comprises:
adjusting an output level of an FPGA, wherein a high level and a low level correspond to different states of the output terminal, respectively.

11. The method according to claim 8, wherein the adjusting at least one control parameter comprises:
setting a reference voltage, wherein the reference voltage corresponds to the sampling threshold; and
adjusting a value of time for the output of the dynamic current.

12. The method according to claim 9, wherein the adjusting an enabled state of an output terminal comprises:
controlling the enabled state to be a disabled state for a predetermined time after the drain voltage of the PA is switched on.

13. A computer program comprising which, when executed by the CPU of the circuit of claim 4 or claim 6, cause the circuit to perform the method according to claim 8.

## Patentansprüche

1. Schutzschaltung, umfassend ein Detektionsmodul (10), ein Vergleichsmodul (12) und ein Antwortmodul (14), wobei das Detektionsmodul (10) mit einem Drain eines Leistungsverstärkers, PA, verbunden ist und dazu konfiguriert ist, einen dynamischen Strom in dem Drain des PA zu detektieren und den dynamischen Strom an das Vergleichsmodul (12) auszugeben;
das Vergleichsmodul (12) mit dem Detektionsmodul (10) verbunden ist und dazu konfiguriert ist, als Reaktion auf das Bestimmen, dass der dynamische Strom größer als ein Abtastschwellenwert ist, nach einer ersten Antwortzeit, die mit dem Bestimmen beginnt, dass der dynamische Strom größer als der Abtastschwellenwert ist, ein Steuersignal an das Antwortmodul (14) auszugeben; und
das Antwortmodul (14) mit dem Vergleichsmodul (12) verbunden ist und dazu konfiguriert ist, das Ausschalten oder Einschalten einer Drainspannung des PA basierend auf dem Steuersignal nach einer zweiten Antwortzeit, die mit dem Empfangen des Ausgangssteuersignals beginnt, zu steuern,
wobei die Schaltung ferner ein anpassbares Referenzmodul (20) umfasst, das verbunden ist mit: dem Detektionsmodul (10), um den Abtastschwellenwert für den dynamischen Strom anzupassen; dem Vergleichsmodul (12), um die erste Antwortzeit anzupassen; und dem Antwortmodul (14), um die zweite Antwortzeit anzupassen.

2. Schaltung nach Anspruch 1, ferner umfassend:
ein Verzögerungsmodul, das mit dem Vergleichsmodul verbunden ist und dazu konfiguriert ist, einen Zustand eines aktivierten Anschlusses des Vergleichsmoduls zu steuern.

3. Schaltung nach Anspruch 2, wobei das anpassbare Referenzmodul Folgendes umfasst:
einen anpassbaren Widerstand, der zwischen einem Erdungsanschluss und dem Vergleichsmodul verbunden ist und dazu konfiguriert ist, eine Referenzspannung des Vergleichsmoduls anzupassen, wobei die Referenzspannung dem Abtastschwellenwert entspricht.

4. Schaltung nach Anspruch 2, wobei das anpassbare Referenzmodul eine zentrale Verarbeitungseinheit, CPU, ein feldprogrammierbares Gate-Array, FPGA, und einen Digital-Analog-Wandler, DAC, umfasst, wobei
ein Eingangsanschluss der CPU dazu konfiguriert ist, eine Steueranweisung zu empfangen, und ein Ausgangsanschluss der CPU mit dem FPGA verbunden ist und dazu konfiguriert ist, das FPGA basierend auf der Steueranweisung zu steuern;
ein Eingangsanschluss des FPGA mit der CPU verbunden ist und ein Ausgangsanschluss des FPGA mit dem DAC und dem Vergleichsmodul verbunden ist und dazu konfiguriert ist, den Zustand des aktivierten Anschlusses durch Anpassen eines Ausgangspegels zu steuern und eine Referenzspannung einzustellen, wobei die Referenzspannung dem Abtastschwellenwert entspricht;
ein Eingangsanschluss des DAC mit dem FPGA verbunden ist und ein Ausgangsanschluss des DAC mit dem Vergleichsmodul verbunden ist und dazu konfiguriert ist, die Referenzspannung auszugeben.

5. Schaltung nach Anspruch 2, wobei das anpassbare Referenzmodul mindestens eines umfasst von:
einem ersten Kondensator, der zwischen dem Detektionsmodul und dem Vergleichsmodul verbunden ist und dazu konfiguriert ist, einen Zeitwert für die Ausgabe des dynamischen Stroms an das Vergleichsmodul anzupassen;
einer Anpassungseinheit, die einen ersten Widerstand und einen zweiten Kondensator umfasst und dazu konfiguriert ist, einen Zeitwert für die Ausgabe des dynamischen Stroms an das Vergleichsmodul anzupassen, wobei der erste Widerstand zwischen dem Erdungsanschluss und dem Vergleichsmodul verbunden ist und der zweite Kondensator parallel zu dem ersten Widerstand zwischen dem Erdungsanschluss und dem Vergleichsmodul verbunden ist; und
einer Widerstands-Kapazitäts-, RC-, Phasenverschiebungsschaltung, die parallel zu einem Gate-Eingangsanschluss des PA verbunden ist, wobei die RC-Phasenverschiebungsschaltung einen zweiten Widerstand und einen dritten Kondensator umfasst und dazu konfiguriert ist, eine zweite Antwortzeit anzupassen, wobei der zweite Widerstand zwischen dem Gate-Eingangsanschluss und dem Erdungsanschluss verbunden ist und der dritte Kondensator zwischen dem Gate-Eingangsanschluss und dem Erdungsanschluss verbunden ist.

6. Schaltung nach Anspruch 2, wobei das anpassbare Referenzmodul eine CPU, ein FPGA und eine erste Zählerschaltung umfasst, wobei
ein Eingangsanschluss der CPU dazu konfiguriert ist, eine Steueranweisung zu empfangen, und ein Ausgangsanschluss der CPU mit dem FPGA verbunden ist und dazu konfiguriert ist, das FPGA basierend auf der Steueranweisung zu steuern,
ein Eingangsanschluss des FPGA mit der CPU verbunden ist und ein Ausgangsanschluss des FPGA mit der ersten Zählerschaltung verbunden ist und dazu konfiguriert ist, die erste Zählerschaltung zu steuern,
ein Eingangsanschluss der ersten Zählerschaltung mit dem FPGA verbunden ist und ein Ausgangsanschluss der ersten Zählerschaltung mit dem Vergleichsmodul verbunden ist und dazu konfiguriert ist, die erste Antwortzeit zu steuern.

7. Schaltung nach Anspruch 2, wobei das Verzögerungsmodul mindestens eines umfasst von:
einer RC-Phasenverschiebungsschaltung, die einen vierten Kondensator und einen dritten Widerstand umfasst, und eine Einschaltsequenz des aktivierten Anschlusses durch Anpassen eines Widerstandswerts des dritten Widerstands und eines Kapazitätswerts des vierten Kondensators angepasst wird, und
einer zweiten Zählerschaltung, die dazu konfiguriert ist, einen Einschaltpegel des aktivierten Anschlusses anzupassen, um einen Zustand des aktivierten Anschlusses zu steuern.

8. Schaltungsschutzverfahren, umfassend:
Anpassen eines Abtastschwellenwerts für einen dynamischen Strom mit einem anpassbaren Referenzmodul (20), das mit einem Detektionsmodul (10) verbunden ist;
Anpassen einer ersten Antwortzeit mit dem anpassbaren Referenzmodul (20), das mit einem Vergleichsmodul (12) verbunden ist;
Anpassen einer zweiten Antwortzeit mit dem anpassbaren Referenzmodul (20), das mit einem Antwortmodul (14) verbunden ist;
Detektieren eines dynamischen Stroms in einem Drain eines Leistungsverstärkers, PA, mit dem Detektionsmodul (10), das mit dem Drain des PA verbunden ist;
Ausgeben des dynamischen Stroms an das Vergleichsmodul (12) mit dem Detektionsmodul (10);
Ausgeben eines Steuersignals an das Antwortmodul (14) nach der ersten Antwortzeit als Reaktion auf das Bestimmen, dass der dynamische Strom größer als der Abtastschwellenwert ist, mit dem Vergleichsmodul (12), das mit dem Detektionsmodul (10) verbunden ist; und
Steuern des Ausschaltens oder Einschaltens einer Drainspannung des PA basierend auf dem Steuersignal nach der zweiten Antwortzeit, die mit dem Empfangen des Ausgangssteuersignals beginnt, mit dem Antwortmodul (14), das mit dem Vergleichsmodul (12) verbunden ist.

9. Verfahren nach Anspruch 8 vor dem Ausgeben eines Steuersignals, wobei das Verfahren ferner Folgendes umfasst:
Anpassen eines aktivierten Zustands eines Ausgangsanschlusses, wobei der Ausgangsanschluss dazu konfiguriert ist, das Steuersignal auszugeben.

10. Verfahren nach Anspruch 9, wobei das Anpassen eines aktivierten Zustands eines Ausgangsanschlusses Folgendes umfasst:
Anpassen eines Ausgangspegels eines FPGA, wobei ein hoher Pegel und ein niedriger Pegel jeweils verschiedenen Zuständen des Ausgangsanschlusses entsprechen.

11. Verfahren nach Anspruch 8, wobei das Anpassen mindestens eines Steuerparameters Folgendes umfasst:
Einstellen einer Referenzspannung, wobei die Referenzspannung dem Abtastschwellenwert entspricht; und
Anpassen eines Zeitwerts für die Ausgabe des dynamischen Stroms.

12. Verfahren nach Anspruch 9, wobei das Anpassen eines aktivierten Zustands eines Ausgangsanschlusses Folgendes umfasst:
Steuern des aktivierten Zustands auf einen deaktivierten Zustand für eine vorbestimmte Zeit, nachdem die Drainspannung des PA eingeschaltet wurde.

13. Computerprogramm das Instruktion aufweist, die wenn sie von der CPU der Schaltung nach Anspruch 4 oder Anspruch 6 ausgeführt werden, die Schaltung veranlassen, das Verfahren nach Anspruch 8 auszuführen.

## Revendications

1. Circuit de protection, comprenant un module de détection (10), un module de comparaison (12) et un module de réponse (14), le module de détection (10) étant connecté à un drain d'un amplificateur de puissance, PA, et étant configuré pour détecter un courant dynamique dans le drain du PA et délivrer le courant dynamique au module de comparaison (12) ;
le module de comparaison (12) étant connecté au module de détection (10) et configuré pour, en réponse à la détermination que le courant dynamique est supérieur à un seuil d'échantillonnage, délivrer un signal de commande au module de réponse (14) après un premier temps de réponse à compter de la détermination que le courant dynamique est supérieur au seuil d'échantillonnage ; et le module de réponse (14) étant connecté au module de comparaison (12) et configuré pour commander l'interruption ou l'application d'une tension de drain du PA sur la base du signal de commande après un deuxième temps de réponse à compter de la réception du signal de commande délivré ;
le circuit comprenant en outre un module de référence ajustable (20), connecté : au module de détection (10) pour ajuster le seuil d'échantillonnage pour le courant dynamique ; au module de comparaison (12) pour ajuster le premier temps de réponse ; et au module de réponse (14) pour ajuster le deuxième temps de réponse.

2. Circuit selon la revendication 1, comprenant en outre :
un module de retard, connecté au module de comparaison et configuré pour commander un état d'une borne d'activation du module de comparaison.

3. Circuit selon la revendication 2, dans lequel le module de référence ajustable comprend :
une résistance ajustable, connectée entre une borne de masse et le module de comparaison et configurée pour ajuster une tension de référence du module de comparaison, la tension de référence correspondant au seuil d'échantillonnage.

4. Circuit selon la revendication 2, dans lequel le module de référence ajustable comprend une unité centrale de traitement, CPU, un réseau de portes programmables in situ, FPGA, et un convertisseur numérique-analogique, DAC,
une borne d'entrée de la CPU étant configurée pour recevoir une instruction de commande, et une borne de sortie de la CPU étant connectée au FPGA et configurée pour commander le FPGA sur la base de l'instruction de commande ;
une borne d'entrée du FPGA étant connectée à la CPU, et une borne de sortie du FPGA étant connectée au DAC et au module de comparaison et configurée pour commander l'état de la borne d'activation en ajustant un niveau de sortie et en établissant une tension de référence, la tension de référence correspondant au seuil d'échantillonnage ;
une borne d'entrée du DAC étant connectée au FPGA, et une borne de sortie du DAC étant connectée au module de comparaison et configurée pour délivrer la tension de référence.

5. Circuit selon la revendication 2, dans lequel le module de référence ajustable comprend au moins un élément parmi :
un premier condensateur, connecté entre le module de détection et le module de comparaison et configuré pour ajuster une valeur de temps pour la délivrance du courant dynamique au module de comparaison ;
une unité d'ajustement, comprenant une première résistance et un deuxième condensateur et configurée pour ajuster une valeur de temps pour la délivrance du courant dynamique au module de comparaison, la première résistance étant connectée entre la borne de masse et le module de comparaison, et le deuxième condensateur étant connecté en parallèle avec la première résistance entre la borne de masse et le module de comparaison ; et
un circuit résistance-capacité, RC, de déphasage connecté en parallèle avec une borne d'entrée de grille du PA, le circuit RC de déphasage comprenant une deuxième résistance et un troisième condensateur et étant configuré pour ajuster un deuxième temps de réponse, la deuxième résistance étant connectée entre la borne d'entrée de grille et la borne de masse, et le troisième condensateur étant connecté entre la borne d'entrée de grille et la borne de masse.

6. Circuit selon la revendication 2, dans lequel le module de référence ajustable comprend une CPU, un FPGA et un premier circuit compteur,
une borne d'entrée de la CPU étant configurée pour recevoir une instruction de commande, et une borne de sortie de la CPU étant connectée au FPGA et configurée pour commander le FPGA sur la base de l'instruction de commande ;
une borne d'entrée du FPGA étant connectée à la CPU, et une borne de sortie du FPGA étant connectée au premier circuit compteur et configurée pour commander le premier circuit compteur ;
une borne d'entrée du premier circuit compteur étant connectée au FPGA, et une borne de sortie du premier circuit compteur étant connectée au module de comparaison et configurée pour commander le premier temps de réponse.

7. Circuit selon la revendication 2, dans lequel le module de retard comprend au moins un élément parmi :
un circuit RC de déphasage, comprenant un quatrième condensateur et une troisième résistance, et une séquence de mise sous tension de la borne d'activation étant ajustée par ajustement d'une valeur de résistance de la troisième résistance et une valeur de capacité du quatrième condensateur ; et
un deuxième circuit compteur, configuré pour ajuster un niveau de mise sous tension de la borne d'activation afin de commander un état de la borne d'activation.

8. Procédé de protection de circuit, comprenant :
l'ajustement d'un seuil d'échantillonnage d'un courant dynamique au moyen d'un module de référence ajustable (20) connecté à un module de détection (10) ;
l'ajustement d'un premier temps de réponse au moyen du module de référence ajustable (20) connecté à un module de comparaison (12) ;
l'ajustement d'un deuxième temps de réponse au moyen du module de référence ajustable (20) connecté à un module de réponse (14) ;
la détection d'un courant dynamique dans un drain d'un amplificateur de puissance, PA, au moyen du module de détection (20) connecté au drain du PA ;
la délivrance du courant dynamique au module de comparaison (12) au moyen du module de détection (20) ;
la délivrance d'un signal de commande au module de réponse (14) après le premier temps de réponse en réponse à la détermination que le courant dynamique est supérieur au seuil d'échantillonnage au moyen du module de comparaison (12) connecté au module de détection (10) ; et
la commande de l'interruption ou de l'application d'une tension de drain du PA sur la base du signal de commande après le deuxième temps de réponse à compter de la réception du signal de commande délivré au moyen module de réponse (14) connecté au module de comparaison (12).

9. Procédé selon la revendication 8, le procédé comprenant en outre, avant la délivrance d'un signal de commande :
l'ajustement d'un état d'activation d'une borne de sortie, la borne de sortie étant configurée pour délivrer le signal de commande.

10. Procédé selon la revendication 9, dans lequel l'ajustement d'un état d'activation d'une borne de sortie comprend :
l'ajustement d'un niveau de sortie d'un FPGA, un niveau haut et un niveau bas correspondant respectivement à des états différents de la borne de sortie.

11. Procédé selon la revendication 8, dans lequel l'ajustement d'au moins un paramètre de commande comprend :
l'établissement d'une tension de référence, la tension de référence correspondant au seuil d'échantillonnage ; et
l'ajustement d'une valeur de temps pour la délivrance du courant dynamique.

12. Procédé selon la revendication 9, dans lequel l'ajustement d'un état d'activation d'une borne de sortie comprend :
la commande de l'état d'activation de manière à le placer dans un état de désactivation pendant une durée prédéterminée après l'application de la tension de drain du PA.

13. Programme d'ordinateur comprenant qui, lorsqu'elles sont exécutées par la CPU du circuit de la revendication 4 ou la revendication 6, amènent le circuit à réaliser le procédé selon la revendication 8.
